Europäisches Patentamt

European Patent Office

Office européen des brevets

(19)

(11) Veröffentlichungsnummer: **0 121 732**

**B1**

(12) # EUROPÄISCHE PATENTSCHRIFT

(45) Veröffentlichungstag der Patentschrift:
18.05.88

(51) Int. Cl.⁴: **G 01 R 25/08**

(21) Anmeldenummer: **84102189.2**

(22) Anmeldetag: **01.03.84**

(54) **Verfahren zur digitalen Phasenmessung.**

(30) Priorität: **03.03.83 CH 1168/83**

(43) Veröffentlichungstag der Anmeldung:
**17.10.84 Patentblatt 84/42**

(45) Bekanntmachung des Hinweises auf die Patenterteilung:
**18.05.88 Patentblatt 88/20**

(84) Benannte Vertragsstaaten:
**DE FR**

(56) Entgegenhaltungen:
**DD-A-61 312**
**FR-A-2 287 703**
**GB-A-1 439 553**

(73) Patentinhaber: **WILD HEERBRUGG AG., CH- 9435 Heerbrugg (CH)**

(72) Erfinder: **Stössel, Hans R., Wolkenberg, CH- 9445 Rebstein (CH)**

(74) Vertreter: **EGLI- EUROPEAN PATENT ATTORNEYS, Horneggstrasse 4, CH- 8008 Zürich (CH)**

EP 0 121 732 B1

0 121 732

**Beschreibung**

Die Erfindung betrifft ein Verfahren zur digitalen Messung der Phasendifferenz F zwischen zwei gleichfrequenten periodischen Signalen U, V, von denen das eine dem anderen phasenmässig vorauseilt, gemäss dem Oberbegriff des Anspruchs 1.

Gemäss FR-A-2 287 703 wird bei einem solchen Verfahren ein Taktsignal T erzeugt, dessen Frequenz wesentlich höher liegt als die Frequenz der genannten Signale U, V. Eine Messzählung wird bei einem der Nulldurchgänge T1 des Signals U begonnen und beim unmittelbar darauffolgenden gleichsinnigen Nulldurchgang T2 des Signals V beendet. Die Anzahl der Perioden des Taktsignals T wird während der Messzählung als Messresultat Mi gezählt. Diese Messzählung wird mehrmals wiederholt, und es wird ein Mittelwert M der Messresultate Mi über deren Anzahl n gebildet.

Wenn die Messresultate Mi, die in nicht immer unmittelbar aufeinanderfolgenden Perioden von U erhalten werden, gemäss FR-A-2 287 703 gemittelt werden, bleibt dabei immer eine Unbestimmtheit um den Faktor $2\pi$ bestehen, da der Wert der Phasendifferenz F nur im Bereich $0 \leqslant F \leqslant 2\pi$ eindeutig ist. Es sind wohl Phasenmesser bekannt, welche diese Unbestimmtheit beheben können, sie erfordern jedoch einen beträchtlichen Schaltungsaufwand insbesonders hinsichtlich analoger Schaltkreise.

Eine zumindest teilweise analoge Baugruppe stellt der "Phase Locked Loop"-Kreis (PLL) dar. Wenn dessen Frequenz, die der Taktfrequenz T entspricht, mit der Signalfrequenz moduliert ist, führt dies zu systematischen Unlinearitäten in der Phasenmessung, die auch bei Mittelung über viele Elementarmessungen nicht verschwinden. Das zum PLL-Kreis gehörende Filter muss deshalb ein Tiefpass sehr niedriger Grenzfrequenz sein, wodurch der PLL-Kreis langsam wird. In vielen Fällen ist es schwierig, einen befriedigenden Kompromiss zwischen Linearität und Regelgeschwindigkeit zu finden.

Aufgabe der vorliegenden Erfindung ist es, das Messverfahren dahingehend zu verbessern, dass der zur Durchführung erforderliche Bauaufwand, insbesondere hinsichtlich kostspieliger analoger Schaltungen, auf ein Minimum reduziert ist.

Diese Aufgabe wird erfindungsgemäss durch die im Patentanspruch 1 definierten Merkmale gelöst.

Mit diesen Massnahmen werden die oben geschilderten Schwierigkeiten vermieden, insbesondere werden $2\pi$-Mehrdeutigkeiten im Mebergebnis verhindert.

Im folgenden werden Ausführungsbeispiele der Erfindung anhand von Zeichnungen näher erläutert. Es zeigen:

Fig. 1 das Schaltschema eines als Beispiel beschriebenen Phasenmessers,

Fig. 2 das Chronogramm einer Elementarmessung,

Fig. 3 bis 6 die Streuung einer Elementarmessung in Form einer Normalverteilung sowie die bei der Elementarmessung zu berücksichtigende $2\pi$-Mehrdeutigkeit.

In jeder Signalperiode, in welcher eine Elementarmessung durchgeführt wird, muss auch eine Elementareichung durchgeführt werden, indem die Taktimpulse während der vollen Signalperiode gezählt werden. Division der Elementarmessung Mi durch die Elementareichung Ci ergibt als individuelle Eichung die geeichte Elementarmessung. Zur Ermittlung dieser Werte wird ein Rechner, vorzugsweise ein Microprozessor, verwendet.

In der praktischen Anwendung, z. B. bei Messfrequenzen von einigen kHz, reicht die Rechengeschwindigkeit des Microprozessors nicht aus, um in der für eine Elementarmessung verfügbaren Zeit eine Division auszuführen. Wenn aber das Verhältnis von Signalfrequenz zu Taktfrequenz ausreichend stabil ist, dürfen gemäss der erfindungsgemässen Erkenntnis die Elementarmessungen und die Elementareichungen separat aufsummiert oder gemittelt und die Division nur einmal am Ende der Globalmessung als globale Eichung durchgeführt werden. Dadurch werden nämlich nicht die Elementarmessungen verfälscht, sondern es wird nur ihre Gewichtung bei der Mittelbildung beeinflusst.

Bei individueller Eichung erhält man die Phasendifferenz F als Mittel der elementaren Phasendifferenzen Fi über n Einzelmessungen:

$$(1) \quad F = \frac{1}{n} \sum_{i=1}^{n} Fi = \frac{P}{n} \sum_{i=1}^{n} Mi/Ci$$

wobei Mi = Messzählungen
Ci = Eichzählungen
P = Maßstabsfaktor = Periode bedeuten.

2

Die globale Eichung liefert das Resultat G:

$$(2) \quad G = P \cdot \sum_{i=1}^{n} M_i \Big/ \sum_{i=1}^{n} C_i \quad .$$

Führt man nun folgende abgekürzte Schreibweise ein:

$$\sum = \sum_{i=1}^{n} \quad \text{und} \quad x = \overline{x_i} = \frac{1}{n} \sum x_i$$

und drückt man ferner die elementaren Zählvorgänge durch die normierten Abweichungen vom Mittelwert aus

$$(3)\ m_i = \frac{M_i - M}{C} \text{ und } c_i = \frac{C_i - C}{C},$$

dann erhält man aus (2)

$$(4)\ G = P \cdot \frac{M}{C}$$

und aus (1)

$$(5)\ F = \frac{1}{n} \Sigma \frac{P m_i + G}{c_i + 1}.$$

Nun entwickelt man den Quotienten in einer Reihe:

$$\frac{1}{c_i + 1} = \sum_{j=4}^{\infty} (-c_i)^j = 1 - c_i + c_i^2 \ldots$$

Höhere als zweite Potenz von Abweichungen werden vernachlässigt. Mittelwerte von Abweichungen verschwinden definitionsgemäss.
Somit erhält man

$$(6) \quad F = \frac{1}{n} \sum (P m_i + G) \cdot (1 - c_i + c_i^2)$$

$$= G(1 + \overline{c_i^2}) - \overline{P m_i c_i}$$

$$= G(1 + A) - B \quad .$$

Bei globaler Eichung macht man also einen zur Phasendifferenz P proportionalen Fehler A und einen von dieser unabhängigen Fehler B.

A ist etwa die Standardabweichung der Elementareichungen im Quadrat. B ist die Korrelation von Messung und Eichung. Bei pessimaler Korrelation (Proportionalität zwischen Mi und Ci) wäre B etwa das Produkt der Standardabweichungen von Messung und Eichung.

Man erwartet, dass die Standardabweichung Sg der durch Mittel über n Elementarmessungen gewonnenen Globalmessung um den Faktor $\sqrt{n}$ kleiner ist als die Standardabweichung Se der Elementarmessungen. Globale Eichung ist zulässig, solange der durch sie erzeugte Fehler wesentlich kleiner bleibt als Sg, also etwa solange

$$S_e^2 < S_g = S_e/\sqrt{n} \text{ oder}$$

$$n \cdot S_e^2 < 1.$$

Diese Bedingung ist in den meisten praktisch auftretenden Fällen erfüllt.

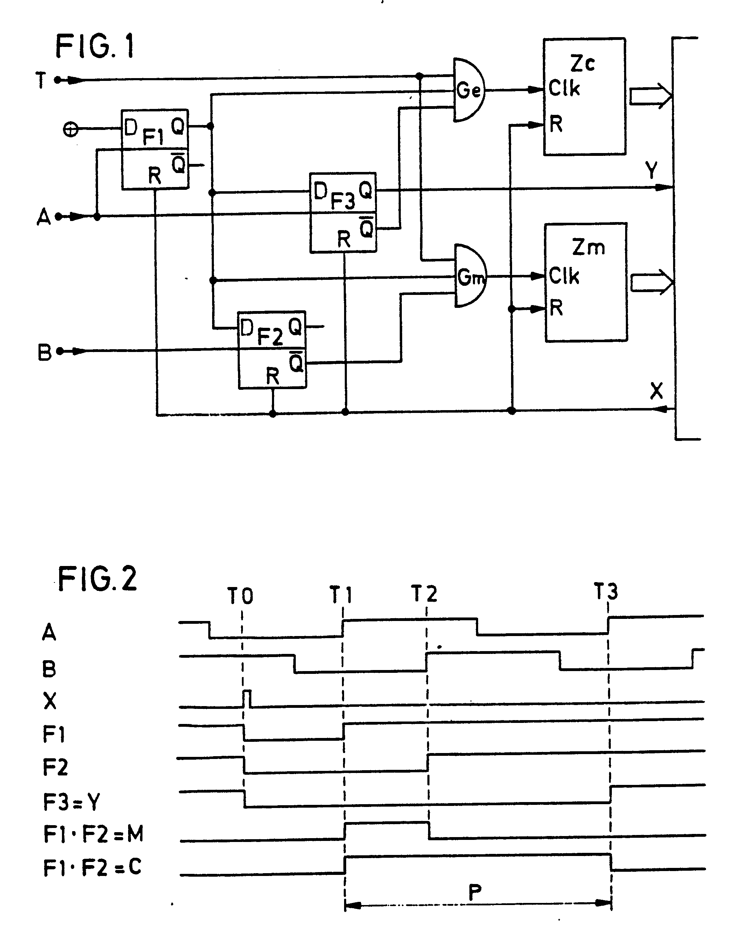

Fig. 1 zeigt ein Schaltschema des Phasenmessers, der abgesehen vom Microprozessor mit den allenfalls nötigen Port-Expandern im wesentlichen nur noch aus drei Flipflops F1, F2, F3, zwei Gates Gm und Ge und zwei Zählern Zm und Zc besteht. F2 und F3 sind Folgeflipflops von F1, d.h. sie können erst gesetzt werden, wenn F1 gesetzt ist. F1 und F3 werden durch die z. B. positive Flanke des Signals U getriggert, F2 durch die gleichsinnige Flanke von V.

Fig. 2 stellt ein Chronogramm einer Elementarmessung dar. Ein zur Zeit TO vom Microprozessor ausgesandter Rückstellimpuls startet eine Elementarmessung, indem er alle Flipflops und Zähler rückstellt. Die erste auf X folgende Schaltflanke von U setzt zur Zeit TI den Flipflop F1, wodurch beide Gates geöffnet werden und den Zählern Taktimpulse zuführen. Die nächste Schaltflanke von U setzt zur Zeit T3 den Flipflop F3, wodurch Ge wieder geschlossen und die Eichzählung beendet wird. In einem Zeitpunkt T2, zwischen T1 und T3, trifft eine Schaltflanke von V ein und setzt den Flipflop F2, wodurch das Gate Gm geschlossen und die Messzählung beendet wird.

Der Zustand von F3 wird als Signal Y dem Rechner zugeführt und meldet diesem, dass die Elementarmessung abgeschlossen ist und gültige Werte in den Zählern anstehen. Y bildet mit X zusammen ein sogenanntes Handshake-System.

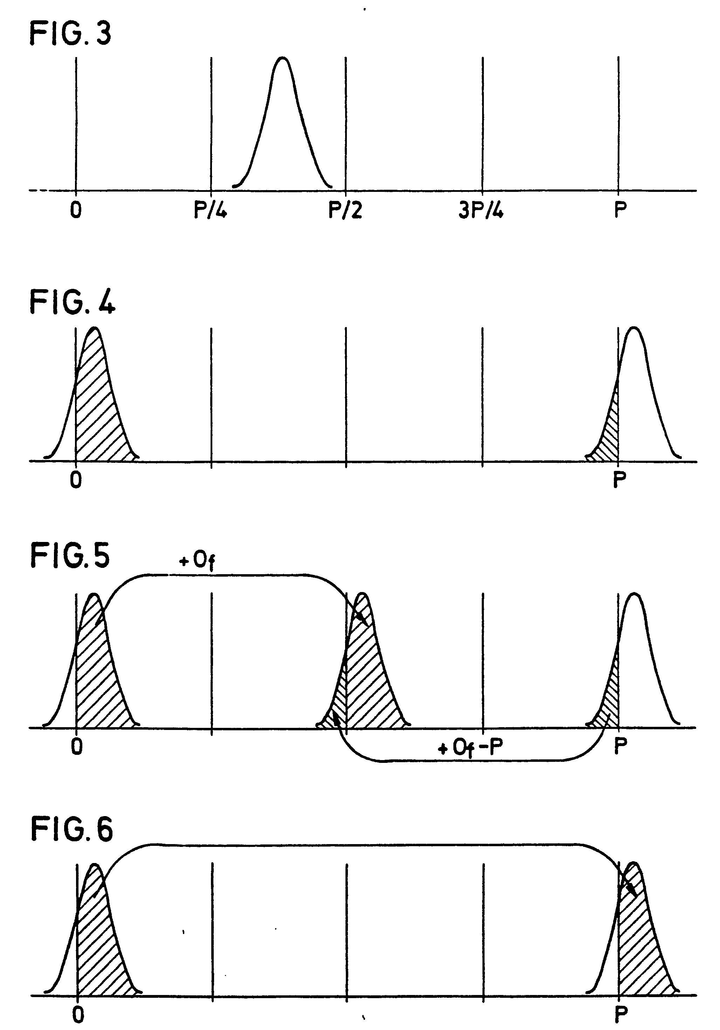

Die so eingelesenen Elementarmessungen sind noch der Mehrdeutigkeit hinsichtlich $2\pi$ unterworfen. Sie streuen um einen Mittelwert, z. B. etwa in Form einer Normalverteilung gemäss Fig. 3. Da die Phasendifferenz modulo P gemessen wird (P = Periode), kann bei Mittelwerten in der Nähe von 0 oder P die Verteilungskurve in zwei weit auseinanderliegende Teile gemäss Fig. 4 zerfallen. Das Mittel solcher werte liegt natürlich nicht im Maximum der Verteilungskurve und ist somit falsch.

Die Wahl der Massnahmen zur Korrektur dieses Fehlers hängt unter anderem davon ab, wie stark die Elementarmessungen streuen. Sind sie über die ganze Periode verteilt, so ist eine sinnvolle Mittelbildung überhaupt nicht möglich. Man muss also mindestens fordern, dass es innerhalb der Periode ein Intervall gebe, in welchem die Dichte der Elementarmessungen vernachlässigbar ist. Wenn diese Voraussetzung mit ausreichender Reserve erfüllt ist, darf man sie auch verschärfen und fordern, dass das von Elementarmessungen freie Intervall eine gewisse Grösse habe, z. B. 2P/3 oder 3P/4. Diese Forderung, die in den meisten Anwendungsfällen gut erfüllt sind, vereinfachen die Behebung der $2\pi$-Mehrdeutigkeit wesentlich.

Teilt man also die Periode in drei oder vier gleich grosse Intervalle, so darf man erwarten, dass höchstens eine Intervallgrenze die Verteilungskurve der Elementarmessungen schneidet. Mittelungsfehler treten dann auf, wenn diese Intervallgrenze der Periodenrand ist.

Üblicherweise wird nun aufgrund einer oder mehrerer Probe-Elementarmessung ein Versatz ermittelt, der dann modulo P zu allen folgenden Elementarmessungen addiert wird und diese in die Nähe der Periodenmitte gemäss Fig. 5 verschiebt.

Man erhält so eine Verteilung, die nicht mehr durch den Periodenrand in zwei Teile geschnitten werden kann, für die somit immer ein sinnvoller Mittelwert existiert. Dieser Mittelwert wird dann später wieder um den Versatz zurückverschoben.

Bekannte Lösungen wählen verschiedene Methoden, um den Versatz bei den Elementarmessungen zu berücksichtigen. Meist geschieht dies schaltungstechnisch durch Manipulation der Eingangssignale U und V, etwa durch Wahl günstig gelegener Flanken, durch Inversion eines Signals, oder schon bei der Erzeugung der Signale, z. B. indem man mehr als zwei Signale erzeugt, aus denen ein günstiges Paar ausgewählt werden kann. Bei allen bekannten Lösungen mit Versatz muss man voraussetzen, dass P schon vor der Messung genau bekannt ist, da man ja den Versatz modulo P zu den Elementarmessungen addieren muss. Diese Voraussetzung ist nicht immer erfüllt, z. B. bei asynchronem Taktsignal und globaler Eichung.

Demgegenüber verzichtet das vorgeschlagene Verfahren auf eine Manipulation der Eingangssignale, wodurch sich Einsparungen an Schaltungsmitteln ergeben. Weiter verzichtet es auf jegliche Korrektur der Elementarmessungen, z. B. Addition eines Versatzes. Die Elementarmessungen werden so aufaddiert, wie sie anfallen, also mit ihrer Mehrdeutigkeit. Korrigiert wird erst die Summe, am Ende der Globalmessung. Dadurch entfällt die Notwendigkeit, bereits während der Vornahme der Elementarmessungen den Wert P genau zu kennen.

Es werden zunächst mittels zweier Schranken a und b = C'-a zwei Randintervalle der Periode definiert, wobei a etwa 1/4 bis 1/3 vom ungefähr bekannten Sollwert C' der Eichzählungen beträgt. Die Summe der Mi ist dann falsch, wenn beide Randintervalle Messungen enthalten, wenn also die Verteilung der Messungen vom Periodenrand zerschnitten wird. Daraus ergibt sich folgende Korrekturregel:

Wenn es $M_i > b$ gibt, dann ist zu allen $M_i < a$ das entsprechende $C_i$ zu addieren.

Da man erst nach Durchführung aller Elementarmessungen weiss, ob zu korrigieren ist, werden diejenigen $C_i$, deren $M_i < a$ sind, separat zu einer Summe $C_a$ aufsummiert. Es werden also während der Messung drei Summen gebildet:

$M = \Sigma M_i$

$C_a = \Sigma C_i \, (M_i < a)$

$C = \Sigma C_i \, (M_i \geqslant a)$.

Im Rechner wird beispielsweise ein Flag Q gesetzt, sobald ein $M_i > b$ anfällt.

Nach der Durchführung der Messung sind dann noch folgende Operationen auszuführen:

$C = C + C_a$ und wenn Q auftritt dann

$M = M + C_a$.

Das entsprechende Ergebnis zeigt Fig. 6.

**Patentansprüche**

1. Verfahren zur digitalen Messung der Phasendifferenz (F) zwischen zwei gleichfrequenten periodischen Signalen (U, V), von denen das eine (U) dem anderen (V) phasenmässig vorauseilt, bei welchem Verfahren

ein Taktsignal (T) erzeugt wird, dessen Frequenz wesentlich höher liegt als die Frequenz der genannten Signale (U, V),

eine Messzählung bei einem der Nulldurchgänge (T1) des vorauseilenden Signals (U) begonnen und beim unmittelbar darauffolgenden, diesem Nulldurchgang (T1) gleichsinnigen Nulldurchgang (T2) des nacheilenden Signals (V) beendet wird, wobei die Anzahl der Perioden des Taktsignals (T) während der Messzählung als Messresultat (Mi) gezählt, diese Messzählung mehrmals wiederholt und ein Mittelwert (M) der Messresultate (Mi) über deren Anzahl (n) gebildet wird,

dadurch gekennzeichnet, dass

eine Eichzählung bei einem der Nulldurchgänge (T1) des vorauseilenden Signals (U) begonnen und beim unmittelbar darauffolgenden, diesem Nulldurchgang (T1) gleichsinnigen Nulldurchgang (T3) desselben Signals (U) beendet wird, wobei die Anzahl der Perioden des Taktsignals (T) während der Eichzählung gezählt und als Eichresultat (Ci) bereitgestellt wird,

die Messzählung (Mi) und die Eichzählung (Ci) gleichzeitig begonnen werden, wodurch das Messresultat (Mi) und das Eichresultat (Ci) einander zugeordnet werden und paarweise ein Messereignis definieren, das mehrmals wiederholt wird, um eine Anzahl (n) von Messereignissen mit jeweils paarweise zugeordneten Messresultaten (Mi) und Eichresultaten (Ci) zu ergeben, je ein Mittelwert (M) der Messresultate (Mi) und ein Mittelwert (C) der Eichresultate (Ci) über die Anzahl (n) von Messereignissen gebildet wird,

und, zur Bildung einer der Phasendifferenz (F) proportionalen Grösse (G) unter Behebung deren Mehrdeutigkeit um eine Anzahl Perioden (P) der Signale (U, V), folgende Verfahrensschritte durchgeführt werden:

aus der Frequenz des Taktsignals (T) und der Periode (P) der Signale (U, V) wird ein angenäherter Sollwert (C') des Mittelwertes (C) der Eichresultate berechnet,

zwei Schranken werden definiert, von denen die erste (a) etwa 1/4 bis 1/3 und die zweite (b) etwa 2/3 bis 3/4 vom Sollwert (C') beträgt,

sobald ein Messresultat (Mi) anfällt, das grösser ist als die zweite Schranke (b), werden diejenigen Eichresultate (Ci), für welche das zugeordnete Messresultat (Mi) kleiner ist als die erste Schranke (a), separat zu einer Summe (Ca) addiert,

ein Korrekturwert wird als Quotient dieser Summe (Ca) durch die Anzahl (n) von Messereignissen gebildet, wobei die Summe (Ca) und folglich der Korrekturwert gleich Null sind, solange kein Messresultat (Mi) angefallen ist, das grösser ist die zweite Schranke (b),

und die der Phasendifferenz (F) proportionale Grösse (G) wird als Quotient der Summe des Mittelwerts (M) der Messresultate und des Korrekturwerts durch den Mittelwert (C) der Eichresultate gebildet.

2. Verfahren nach Anspruch 1, dadurch gekennzeichnet, dass das Taktsignal (T) und die gleichfrequenten Signale (U, V) zueinander asynchron sind.

**Claims**

1. A method of performing digital measurement of the phase difference between two periodic signals (U, V) having the same frequency, of which signals the one (U) is phase-advanced in respect of the other (V), in which method

a clock signal (T) is produced, whose frequency is substantially higher than the frequency of said signals (U, V),

a measurement count is initiated at one of the zero crossings (T1) of the phase-advanced signal (U) and terminated at the very next same direction zero crossing (T2) of the phaseretarded signal (V), whereby the number of periods of the clock signal (T) during the measurement count is counted as a measurement result (Mi), this measurement count is repeated several times and an average value (M) of the measurement results (Mi) is calculated over their number (n),

characterized in that

a calibration count is initiated at one of the zero crossings (T1) of the phase-advanced signal (U) and terminated at the very next same direction zero crossing (T3) of the same signal (U), whereby the number of periods of the clock signal (T) during the calibration count is counted and made available as a calibration result (Ci),

the measurement count (Mi) and the calibration count (Ci) are initiated simultaneously, whereby the measurement result (Mi) and the calibration result (Ci) are assigned in correspondence to each other and define in pairs a measurement event which is repeated several times to give a number (n) of measurement events each having a measurement result (Mi) and a calibration result (Ci) assigned in pairs, an average value (M) of the measurement results (Mi) and an average value (C) of the calibration results (Ci) each are calculated over the number (n) of measurement events,

and, in order to determine a quantity (G) which is proportional to the phase difference (F) while eliminating the indetermination of the latter in respect of a number periods (P) of the signals (U, V), the following method steps are performed:

an approximate desired value (C') of the average value (C) of the calibration results is calculated from the frequency of the clock signal (T) and the period (P) of the signals (U, V),

two limits are defined, the first of which (a) amounts to approximately 1/4 to 1/3 and the second (b) to approximately 2/3 to 3/4 of the desired value (C'),

as soon as there is obtained a measurement result (Mi) which is greater than the second limit (b), those calibration results (Ci) having a respective assigned measurement result (Mi) which is smaller than the first limit (a) are added separately to form a sum (Ca),

a correction value is calculated as the quotient of this sum (Ca) by the number (n) of measurement events, whereby the sum (Ca) and, thus, the correction value are equal to zero as long as no measurement result (Mi) has become available which is greater than the second limit (b),

and the quantity (G) which is proportional to the phase difference (F) is calculated as the quotient of the sum of the average values (M) of the measurement results and of the correction value by the average value (C) of the calibration results.

2. The method of claim 1, characterized in that the clock signal (T) and the signals (U, V) having the same frequency are asynchronous to each other.

## Revendications

1. Procédé de mesure numérique de la différence de phase entre deux signaux périodiques (U, V) de même fréquence dont l'un (U) est en avance de phase sur l'autre (V), procédé dans lequel:

un signal d'horloge (T) est produit à une fréquence sensiblement plus élevée que la fréquence desdits signaux (U, V),

un comptage de mesure est commencé en l'un des passages par zéro (T1) du signal en avance de phase (U) et terminé au tout prochain passage par zéro de même sens (T2) du signal en retard de phase (V), le nombre de périodes du signal d'horloge (T) pendant le comptage de mesure étant compté comme résultat de mesure (Mi), ce comptage de mesure étant répété plusieurs fois et une valeur moyenne (M) des résultats de mesure (Mi) étant calculée sur leur nombre (n),

caractérisé en ce que:

un comptage est commencé en l'un des passages par zéro (T1) du signal en avance de phase (U) et terminé au tout prochain passage par zéro de même sens (T3) du même signal (U), le nombre de périodes du signal d'horloge (T) pendant le comptage d'étalonnage étant compté et rendu disponible comme résultat d'étalonnage (Ci),

le comptage de mesure (Mi) et le comptage d'étalonnage (Ci) sont commencés simultanément, le résultat de mesure (Mi) et le résultat d'étalonnage (Ci) étant assignés en correspondance l'un à l'autre et définissant par paires un événement de mesure qui est répété plusieurs fois pour fournir un nombre (n) d'événements de mesure dont chacun comporte un résultat de mesure (Mi) et un résultat d'étalonnage (Ci) assignes par paires,

on calcule chaque fois une valeur moyenne (M) des résultats de mesure (Mi) et une valeur moyenne (C) des résultats d'étalonnage (Ci) sur le nombre (n) d'événements de mesure,

et, pour déterminer une quantité (G) proportionnelle à la différence de phase (F) tout en éliminant l'indétermination de cette dernière par rapport au nombre de périodes (P) des signaux (U, V), on exécute les étapes de procédé suivantes:

on calcule une valeur désirée approximative (C') de la valeur moyenne (C) des résultats d'étalonnage à partir de la fréquence du signal d'horloge (T) et de la période (P) des signaux (U, V),

on définit deux limites dont la première (a) vaut approximativement 1/4 à 1/3 et la seconde (b) approximativement 2/3 à 3/4 de la valeur désirée (C'),

aussitôt qu'on obtient un résultat de mesure (Mi) plus grand que la seconde limite (b) on additionne séparément ceux des résultats d'étalonnage (Ci) auxquels est assigné un résultat de mesure respectif (Mi) qui est plus petit que la première limite (a), pour former une somme (Ca),

on calcule une valeur de correction comme quotient de cette somme (Ca) par le nombre (n) d'événements de mesure, la somme (Ca) et donc la valeur de correction étant égales à zéro aussi longtemps qu'on n'a obtenu aucun résultat de mesure (Mi) plus grand que la seconde limite (b),

et on calcule la quantité (G) proportionnelle à la différence de phase (F) comme quotient de la somme des valeurs moyennes (M) des résultats de mesure et de la valeur de correction par la valeur moyenne (C) des résultats d'étalonnage.

2. Procédé selon la revendication 1, caractérisé en ce que le signal d'horloge (T) et les signaux (U, V) de même fréquence sont asynchrones l'un par rapport à l'autre.

# FIG.1

# FIG.2

# FIG. 3

| 0 | P/4 | P/2 | 3P/4 | P |

# FIG. 4

0       P

# FIG.5

$+ O_f$

0      $+ O_f - P$     P

# FIG.6

0       P